Europäisches Patentamt

European Patent Office

Office européen des brevets

(19)

(11) **EP 1 304 594 A2**

(12) **EUROPÄISCHE PATENTANMELDUNG**

(43) Veröffentlichungstag:
**23.04.2003  Patentblatt 2003/17**

(51) Int Cl.⁷: $G03F\ 7/20$

(21) Anmeldenummer: **02020850.0**

(22) Anmeldetag: **18.09.2002**

(84) Benannte Vertragsstaaten:
**AT BE BG CH CY CZ DE DK EE ES FI FR GB GR
IE IT LI LU MC NL PT SE SK TR**
Benannte Erstreckungsstaaten:
**AL LT LV MK RO SI**

(30) Priorität: **17.10.2001  DE 10151309**

(71) Anmelder: **CARL ZEISS SEMICONDUCTOR
MANUFACTURING TECHNOLOGIES AG
73446 Oberkochen (DE)**

(72) Erfinder:
• **Ulrich, Wilhelm
  73434 Aalen (DE)**
• **Wagner, Christian
  5521 KS Eersel (NL)**

(74) Vertreter: **Gnatzig, Klaus et al
Carl Zeiss
Patentabteilung
73446 Oberkochen (DE)**

(54) **Projektionsbelichtungsanlage der Mikrolithographie für 200 nm**

(57)     Projektionsbelichtungsanlage der Mikrolithographie

-   mit einer Lichtquelle mit einer Wellenlänge unter
    200 nm und
-   einer Bandbreite kleiner als 0,3 pm vorzugsweise
    unter 0,25 pm und größer als 0,1 pm.
-   mit einem rein refraktiven Projektionsobjektiv mit

nur einem Linsenmaterial, wobei die Ausbildung

-   mit einer größten Bildhöhe über 12 mm bis etwa 25
    mm
-   mit einer bildseitigen numerischen Apertur von über
    0,75 bis etwa 0,95
-   mit einer monochromatischen Korrektur der Wellenfront auf rms < 15‰ der Wellenlänge der Licht-
    quelle erfolgt.

## FIG.2

131.58 MM

**Beschreibung**

Die Erfindung betrifft eine Projektionsbelichtungsanlage der Mikrolithographie mit einer Lichtquelle mit einer Wellenlänge unter 200 nm und einer Bandbreite kleiner als 0,3 pm, vorzugsweise unter 0,2 pm mit einem rein refraktiven Projektionsobjektiv mit nur einem Linsenmaterial.

Dementsprechende Projektionsobjektive sind z.B. aus EP 1 037 267 A1 bekannt. Dort ist die zulässige Bandbreite $\Delta\lambda$. definiert als proportional $L/NA^2$ mit $L$ = Abstand Objektiv zu Bild. Als Beispiel ist ein rein sphärisches Projektionsobjektiv mit 27 Linsen bei NA = 0,6, L = 1000 mm, Verkleinerung β = - 0,25, Brennweite unendlich und größter Bildhöhe Y = 13,2 mm angegeben.

Die Lithographie mit 157 nm Lasern ist in einem Artikel T.M. Blomstein et al. J. Vac. Sci. Technol. B 15(6), Nov./Dec. 1997, p 2112-2116 beschrieben.

Dort wird auch die Möglichkeit von Ein-Material rein refraktiven Lithographiesystemen bei 157 nm beschrieben, mit einer Bandbreiteneinengung des Lasers vergleichbar der bei 193 nm bekannten.

Der Artikel Phil Ware, Canon Submicron Focus, Summer 2000, p. 17 "Clearing the hurdles in the 157 nm race" beschreibt bekannte Kandidaten als Projektionsobjektive für 157 nm. Für refraktive Ein-Material-Projektionsobjektive wird eine Bandbreiteneinengung auf 0,1 — 0,2 pm für nötig gehalten.

Ein entsprechendes Beleuchtungssystem ist beispielsweise aus DE 198 55 106, US Ser.No. 09/449415 bekannt.

Die bekannten Laser bei 193 nm und 157 nm Wellenlänge werden mit bekannten Mitteln in ihrer Bandbreite eingeengt. Das beanspruchte Maß der Bandbreite ist dabei eine Frage der Herstellkosten und des Wirkungsgradverlusts.

Bei reinen Quarzglas-Objektiven für 248 nm und achromatisierten 193 nm Objektiven sind numerische Aperturen von 0,7 bis 0,9 Stand der Technik. Die durch Reduktion der Wellenlänge mögliche Verbesserung der Auflösung kann nur ausgenutzt werden, wenn diese hohe bildseitige numerische Apertur übernommen wird.

Aufgabe der Erfindung ist die Bereitstellung einer gattungsgemäßen Projektionsbelichtungsanlage, welche die Vorteile der reduzierten Wellenlänge wirklich auszunutzen ermöglicht.

Gelöst wird diese Aufgabe dadurch, daß bei einer gattungsgemäßen Projektionsbelichtungsanlage mit einer größten Bildhöhe von über 12 mm bis etwa 25 mm, mit einer bildseitigen numerischen Apertur von über 0,75 bis etwa 0,95 und mit einer monochromatischen Korrektur der Wellenfront in der Bildebene auf rms < 15‰ der Wellenlänge der Lichtquelle keine Abstriche gegenüber den bei höheren Wellenlängen bzw. bei achromatisierten 193 nm Systemen erreichten Werten gemacht werden.

Das große Bildfeld, repräsentiert durch die Bildhöhe, erlaubt einen angemessenen Durchsatz und eine Anpassung an Belichtungsfelder anderer Maschinen für entspanntere Strukturanforderungen. Nur mit der hohen numerischen Apertur ist überhaupt ein Auflösungsgewinn für die Wellenlänge 157 nm gegenüber 193 nm zu erreichen. Die erreichbare Auflösung ist proportional zum Quotienten aus Wellenlänge durch bildseitige numerische Apertur. Dieser Quotient beträgt für 193 nm : 0,9 = 214 nm, ist für 157 nm : 0,6 = 261 deutlich größer und für 157 nm : 0,75 = 209 nm etwa gleich groß. Damit ist für den angegebenen Bereich der numerischen Apertur für 157 nm Wellenlänge eine verbesserte Auflösung möglich. Für größere Wellenlängen im beanspruchten Bereich, speziell 193 nm, bleibt die Qualität gemäß Stand der Technik erhalten.

Die hochwertige Korrektur des Projektionsobjektivs mit dem Wellenfrontfehler in der Bildebene rms < 15‰ monochromatisch stellt sicher, daß die durch die geringe Wellenlänge und hohe Apertur mögliche hohe Auflösung auch wirklich über das große Bildfeld nützlich ist und eine formtreue Abbildung erfolgt. Zum Vergleich gilt ein System mit Bildfehlern von der Größe des Quotienten aus Wellenlänge durch bildseitige numerische Apertur, also mit bis zu hundertfach größerem Fehler, für gewöhnlich in der Optik noch als beugungsbegrenzt.

Vorteilhafte Ausführungsformen sind Gegenstand der Unteransprüche. Dazu gehört besonders auch ein adäquates Beleuchtungssystem nach Anspruch 2. Dieses erlaubt die strukturspezifisch beste Auflösung mit der erfindungsgemäßen Projektionsbelichtungsanlage darzustellen. Ohne ein solches Beleuchtungssystem hat eine 157 nm oder 193 nm Projektionsbelichtungsanlage gegenüber konventionellen bei vielen Strukturarten keine Auflösungsvorteile.

Der Einsatz von asphärischen Linsenflächen nach den Ansprüchen 3 bis 7 ist ein vorteilhaftes Mittel zur Erreichung der anspruchsvollen Parameter des Anspruchs 1, bei sparsamstem Einsatz von Lichtweg im Linsenmaterial - wichtig wegen relativ hoher Absorption und hohen Kosten speziell von $CaF_2$— , und geringer Linsen-/Flächenzahl — wichtig wegen der Herstellkosten und der Reflexionsverluste.

Das Linsenmaterial der Wahl ist gemäß Anspruch 8, speziell für 157 nm, ein Fluorid, und dabei vorzugsweise Kalziumfluorid, aber auch z.B. Bariumfluorid oder Lithiumfluorid. Die Fluoride sind vorzugsweise als Einkristalle einzusetzen und eignen sich als Stoffklasse mit der höchsten Transparenz im Wellenlängenbereich unter 200 nm. Daneben ist auch Quarzglas, speziell bei 193 nm, oder mit Fluordotierung auch bei niedrigeren Wellenlängen bekanntermaßen geeignet.

Anspruch 9 beschreibt die besonders vorteilhafte Situation, daß der Farbfehler im Rahmen der monochromatischen Fehler bleibt und somit die Auflösung nicht signifikant beeinträchtigt. Bei gegebener Dispersion des Linsenmaterials wird dies in Kombination durch Reduzierung der Bandbreite der Lichtquelle und durch Designoptimierung des Projektionsobjektivs erreicht.

Näher erläutert wird die Erfindung anhand der in der Zeichnung dargestellten Beispiele:

Figur 1: zeigt eine schematische Übersicht über die Gesamtanordnung der Projektionsbelichtungsanlage;

Figur 2: zeigt den Linsenschnitt eines Ausführungsbeispiels eines Objektivs;

Figur 3: zeigt den Linsenschnitt eines weiteren Ausführungsbeispiels eines Objektivs; und

Figur 4: zeigt den Linsenschnitt eines dritten Ausführungsbeispiels eines Objektivs.

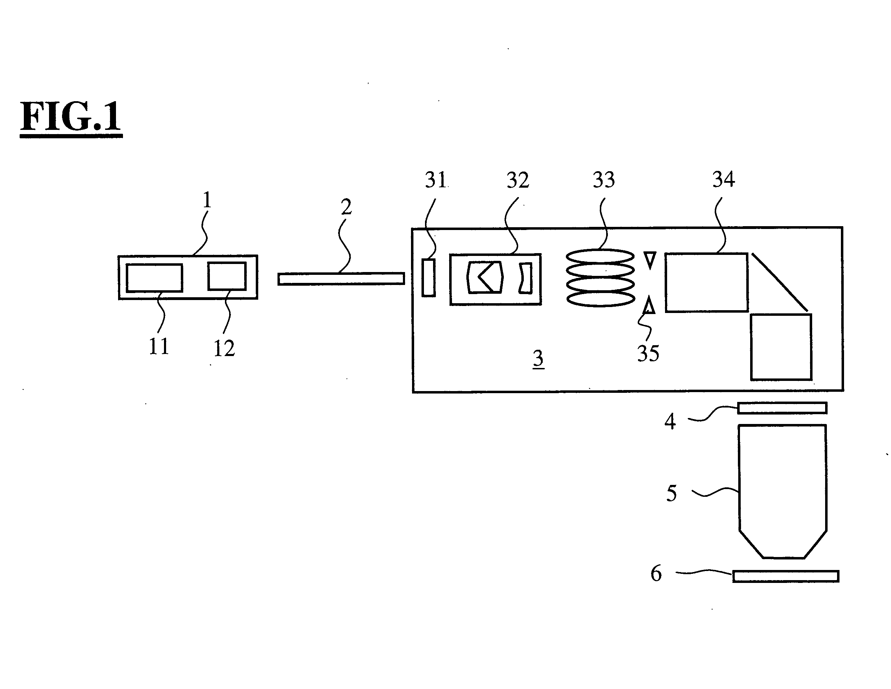

Die Projektionsbelichtungsanlage nach Figur 1 besteht aus einer Lichtquelle 1 mit einer Wellenlänge unter 200 nm, insbesondere einem Ar F Laser 11 mit 193 nm oder einem $F_2$-Laser 11 mit 157 nm und mit einer Einrichtung zur Bandbreiteneinengung 12, die in den Laserresonator integriert sein kann, für eine Bandbreite unter 0,3 pm, vorzugsweise unter 0,25 pm. Extreme Einengungen auf unter 0,1 ppm sind nicht erforderlich.

Die erlaubte Bandbreite wird aus der Forderung abgeleitet, dass der begrenzende Farblängsfehler CHL kleiner als eine halbe Rayleigh-Einheit RE sein soll, d.h. CHL $(\Delta\lambda) < \frac{1}{2} \lambda$ / $NA^2$. Die Bandbreite $\Delta\lambda$ ergibt sich aus dem Quotienten von CHL $(\Delta\lambda)$ und dem auf 1 nm normierten Farblängsfehler CHL (/nm) des Objektivdesigns, sprich

$$\Delta\lambda = \frac{CHL\ (\Delta\lambda)}{CHL\ (/nm)} = \frac{\frac{1}{2}\ \lambda/NA^2}{CHL\ (/nm)}$$

Über eine Ankopplung 2, eine laser beam line, wird das UV-Licht dem Beleuchtungssystem 3 zugeführt. Um optimale Projektions-Mikrolithographie mit dem Laserlicht zu ermöglichen, enthält dieses Beleuchtungssystem 3 Mittel zur Divergenzerhöhung 3, insbesondere ein oder mehrere gerasterte optische Elemente mit diffraktiven oder refraktiven Mikrolinsen oder eine Streuscheibe. Weiter sind integriert Vorrichtungen zur Einstellung der räumlichen Kohärenz o der Beleuchtung und der Beleuchtungsart mit verschiedenen Optionen wie annularer, Dipol- oder Quadrupol-Beleuchtung, vorteilhafterweise mit einer Zoom-Axicon-Gruppe 32 oder anderen umformenden Mitteln, die möglichst wenig Licht ausblenden.

Ein Homogenisator/Lichtmischer/Integrator, besonders ein Wabenkondensor 33 oder ein Glasstab (aus Fluoridkristall) oder ein äquivalenter Spiegelkasten folgt. Er ist auf geringe Wege im transparenten Material ausgelegt.

Ein Objektiv 34 erzeugt eine randscharfe Abbildung einer Retikelmaske (REMA) 35 auf das Retikel (Maske, Strukturvorlage) 4 bei höchster Homogenität der Lichtintensität.

Die Beleuchtung des Retikels 4 erfolgt telezentrisch, vorzugsweise mit Feinanpassung an die Telezentrieeigenschaften des Projektionsobjektivs 5, das nachfolgend anhand der Beispiele näher erläutert wird.

Unter dem Projektionsobjektiv ist das zu belichtende Substrat 6 angeordnet, also üblicherweise ein Wafer zur Herstellung mikroelektronischer Bauelemente, aber auch andere mikrostrukturierte Elemente sind möglich, wie mikrooptische oder mikromechanische Elemente.

Retikel 4 und Substrat 6 werden gegenüber Projektionsobjektiv 5 und Beleuchtungssystem 3 hochpräzise positioniert und zu step-and-repeat oder step-and-scan oder stitching exakt bewegt.

Wegen der hohen Absorption des UV-Lichts von unter 200 nm Wellenlänge ist der Lichtweg von stark absorbierenden Stoffen wie Wasserdampf freigehalten. Wegen der hohen UV-Lichtleistung ist zur Vermeidung photochemischer Korrosion die Atmosphäre besonders von $O_2$ freizuhalten. Maßnahmen zur Vorhaltung einer Sonderatmosphäre im Bereich der Optiken sind daher notwendig. Stickstoff und Helium sind geeignete Gase, daneben ist Vakuum vorteilhaft.

Für das Projektionsobjektiv 6 werden im weiteren detaillierte Ausführungsbeispiele rein refraktiver Objektive aus nur einem Linsenmaterial angegeben.

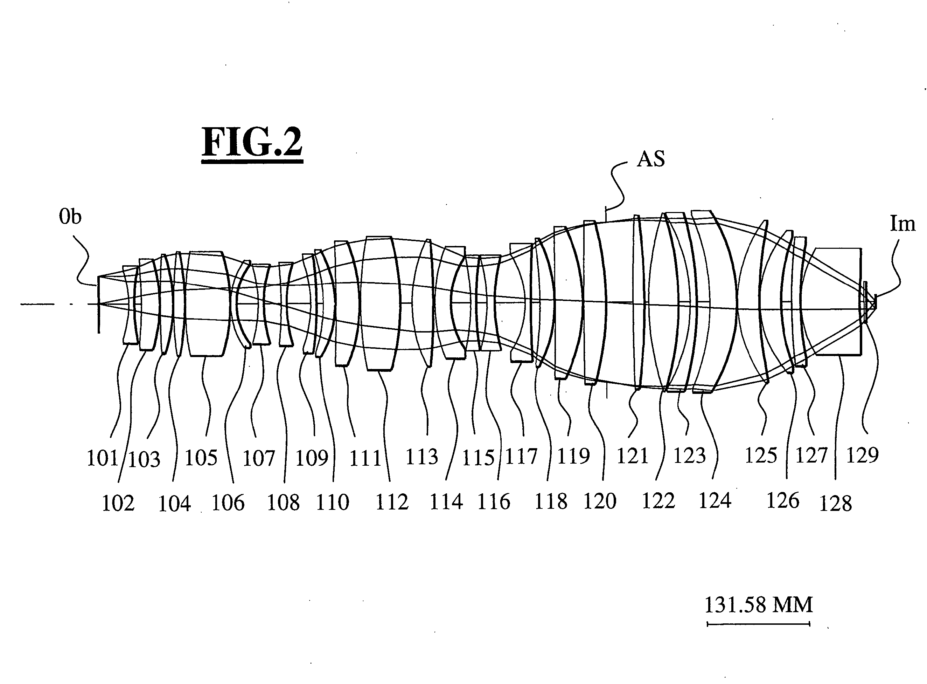

Das Beispiel nach Figur 2 und Tabelle 1 hat:

| Abbildungsmaßstab | $\beta = -\frac{1}{4}$ |
|---|---|
| bildseitige numerische Apertur | NA = 0,75 |
| Bildfeld | 17 x 6 mm$^2$ (für Stitching) |
| Baulänge (Abstand Ob-Im) | 1000 mm |

(fortgesetzt)

| Betriebswellenlänge ($F_2$-Laser) | 157 nm |
|---|---|
| rms des monochromatischen Wellenfrontfehlers, Maximum davon über das ganze Bildfeld | 10 m λ (1,57nm) |
| chromatische Längsaberration CHL (1 nm) | 0.64 pm/nm |
| brauchbare Laserbandbreite | 0,22 pm |
| Auflösung | ∼ 100 nm |
| größter Linsendurchmesser | 225 mm |

Die angegebene Auflösung res wird nach der Formel res = $K_1$ λ/NA mit $K_1$ (Prozessparameter) = 0.5 berechnet.

Zwischen Objektebene Ob- und Bildebene Im weist das Objektiv 28 Linsen 121 bis 128 und eine planparallele Abschlußplatte 29 auf, alle aus $CaF_2$ Einkristall. Das Objektiv weist eine für Mikrolithographie-Projektionsobjektive bekannte Grundform mit zwei Strahltaillen mit jeweils mehreren Negativlinsen (101, 107 — 109 und 114 — 117) auf. Objektseitig eröffnet eine bikonkave Linse 101 nach hinreichend großem Arbeitsabstand die Linsenfolge.

Die Systemapertur AS liegt im Bereich des lang ausgedehnten dritten Bauches, für den eine negative Meniskenlinse (123) signifikant ist.

Drei Asphären-Flächen auf den Linsen 105, 109, 127 erhöhen die Korrektur-Freiheitsgrade soweit, daß mit der beschränkten Linsenzahl die hohe Abbildungsqualität erreicht wird.

Zwei Asphären im Bereich des ersten Bauchs und der ersten Taille sind dem Bild zugewandt, die bildseitig letzte Asphäre des Objektivs ist dem Bild abgewandt. Alle Asphären befinden sich auf konvexen Flächen, wo sie etwas einfacher zu fertigen und zu prüfen sind.

Keine Asphäre liegt nahe an der Systemapertur AS.

Natürlich sind auch mehr Asphären nützlich. Es sind jedoch stets wegen des erheblich höheren Aufwands für Fertigung und Prüfung möglichst wenige Asphären einzusetzen.

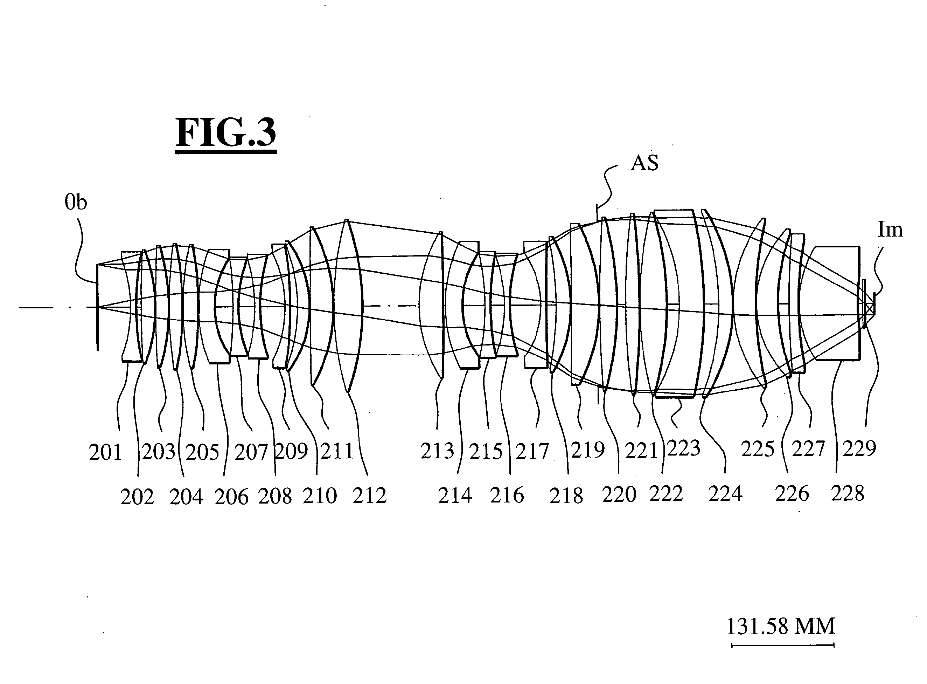

Das zweite Ausführungsbeispiel nach Figur 3 und Tabelle 2 zeigt gleiche Güte bei gesteigertem Bildfeld, das noch für klassisches step-and-scan Verfahren geeignet ist.

Es hat:

| Abbildungsmaßstab | β = - ¼ |
|---|---|
| bildseitige numerische Apertur | NA = 0,75 |
| Bildfeld | 26 x 8 mm² |
| Baulänge (Abstand Ob-Im) | 1000 mm |
| Betriebswellenlänge ($F_2$-Laser) | 157 nm |
| rms des monochromatischen Wellenfrontfehlers, Maximum davon über das ganze Bildfeld | 11 mλ |
| chromatische Längsaberration CHL (1 nm) | 0.72 µm/nm |
| brauchbare Laserbandbreite | 0.19 pm |
| Auflösung | ≈ 100 nm |
| größter Linsendurchmesser | 235 mm |

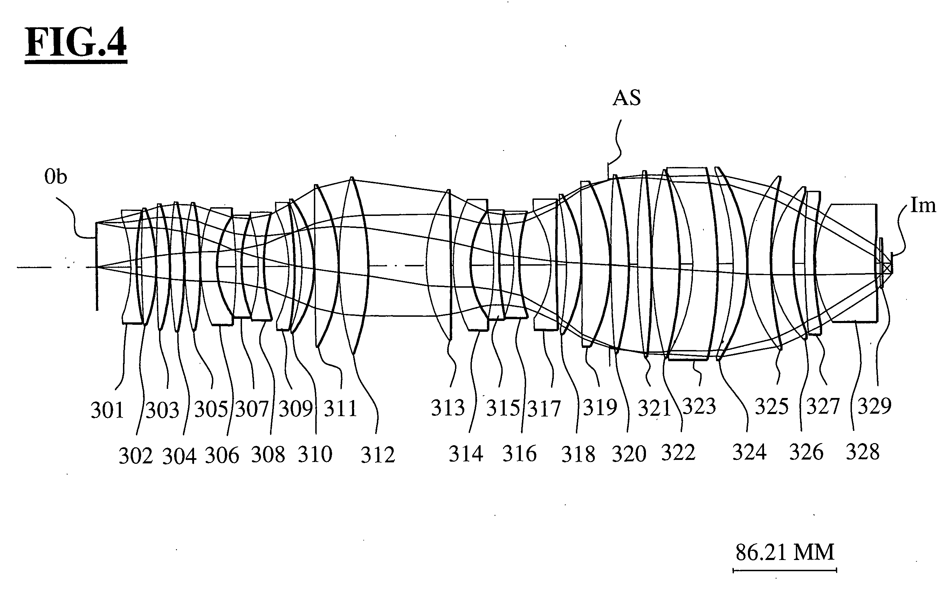

Das dritte Ausführungsbeispiel nach Figur 4 und Tabelle 3 ist ein Stitching-Objektiv mit auf 2/3 reduzierter Baulänge zwischen Objekt Ob und Bildebene Im. Konsequent tritt eine entsprechende Verringerung der Absorptionsverluste durch kürzeren Weg in den Linsen und eine Reduzierung des $CaF_2$-Materialeinsatzes auf weniger als die Hälfte des Volumens ein, was eine erhebliche Verbilligung darstellt.

Auch mit diesem Ansatz ist ein Projektionsobjektiv mit sonst gleichwertigen bis besseren Eigenschaften dargestellt:

| Abbildungsmaßstab | β = - ¼ |
|---|---|
| bildseitige numerische Apertur | NA = 0,75 |
| Bildfeld | 17 x 6 mm² |
| Baulänge (Abstand Ob-Im) | 663 mm |
| Betriebswellenlänge ($F_2$-Laser) | 157 nm |
| rms des monochromatischen Wellenfrontfehlers, Maximum davon über das ganze Bildfeld | 7 mλ |
| chromatische Längsaberration CHL (1 nm) | 0.48 µm/nm |

(fortgesetzt)

| | |
|---|---|
| brauchbare Laserbandbreite | 0.29 pm |
| Auflösung | ~ 100 nm |
| größter Linsendurchmesser | 156 mm |

Die Linsenschnitte des zweiten und dritten Beispiels zeigen große Ähnlichkeit. In erster Näherung kann das dritte Beispiel maßstäblich verkleinert aus dem zweiten abgeleitet werden. Eine Eigenart ist die große freie Driftstrecke im Bereich des zweiten Bauches. Ansonsten sind die auch im ersten Beispiel vorliegenden Eigenarten auch vorzufinden.

Insgesamt zeigt die Erfindung, daß es auch mit nicht durch zwei Linsenmaterialien achromatisierten rein refraktiven Projektionsobjektiven gelingt, mit zugänglichen Laserbandbreiten auszukommen, bei 157 nm und damit auch bei 193 nm. Dies gilt auch für die für einen wirklichen Nutzen der niedrigen Wellenlängen erforderlichen hohen bildseitigen numerischen Aperturen. Geeignete Beleuchtungssysteme mit der erforderlichen Flexibilität in der Bereitstellung verschiedener Beleuchtungsmodi liegen vor. Eine Verkleinerung des Bildfelds — stitching — entspannt die Konstruktion insbesondere hinsichtlich des Einsatzes des teuren Linsenmaterials.

TABELLE 1

| ELEMENT NUMMER | RADIUS FRONT | HINTEN | DICKE | ÖFFNUNG DURCHMESSER FRONT |
|---|---|---|---|---|
| OB | INF | 21.2160 80.5345 7.2553 | | |
| 101 | -115.7621 CC | 213.1810 CC 4.2404 | 4.6410 | 80.5443 |
| 102 | 792.2783 CX | -136.4601 CX 0.3315 | 12.3286 | 90.2142 |
| 103 | 1067.0745 CX | -181.7748 CX 0.3315 | 11.0939 | 98.4446 |
| 104 | 378.1984 CX | -265.5741 CX 0.3315 | 11.4883 | 102.3597 |
| 105 | 224.6510 CX | A(1) 0.3315 | 12.9746 | 101.2653 |
| 106 | 133.5672 CX | 71.0135 CC 15.6747 | 13.6914 | 92.4091 |
| 107 | -337.6630 CC | 109.9077 CC 14.0503 | 4.6410 | 80.0859 |
| 108 | -131.6748 CC | 150.8187 CC 20.8572 | 4.6410 | 78.5863 |
| 109 | -104.0376 CC | A(2) 6.1949 | 4.6410 | 89.9352 |
| 110 | -143.8077 CC | -93.3047 CX 0.6281 | 10.1477 | 102.5910 |
| 111 | 5969.0673 CX | -134.8494 CX 0.3315 | 19.7977 | 126.6423 |
| 112 | 263.7742 CX | -215.7957 CX 48.1858 | 24.3807 | 140.6339 |
| 113 | 113.7579 CX | -2952.2070 CX 1.8185 | 20.6518 | 119.8425 |
| 114 | 122.7460 CX | 75.1878 CC 19.3036 | 14.5159 | 103.7065 |
| 115 | -201.8765 CC | 212.7200 CC 12.0563 | 4.6410 | 86.2873 |

TABELLE 1  (fortgesetzt)

| ELEMENT NUMMER | RADIUS FRONT | HINTEN | DICKE | ÖFFNUNG DURCHMESSER FRONT |
|---|---|---|---|---|
| 116 | -119.9368 CC | 140.1595 CC 6.4165 | 4.6410 | 82.0743 |
| 117 | -75.1970 CC | 2139.9405 CC 8.1650 | 4.6924 | 87.3250 |
| 118 | -272.6518 CC | -115.0768 CX 0.4687 | 12.5284 | 107.0978 |
| 119 | -5512.2722 CC | - 144.7103 CX 0.4584 | 23.6457 | 126.2784 |
| 120 | 970.7047 CX | - 274.1440 CX -16.5750 | 14.9265 | 141.2732 |
| | | APERTUR STOP 21.7740 145.4872 1.9890 | | 139.9019 |
| 121 | 571.8065 CX | -697.0709 CX 0.3315 | 11.7771 | 148.1741 |
| 122 | 301.5827 CX | -274.0065 CX 10.8509 | 22.9521 | 150.2673 |
| 123 | -146.5289 CC | -353.9458 CX 12.8151 | 20.8507 | 149.5282 |
| 124 | -213.2199 CC | -145.9024 CX 0.3321 | 11.9362 | 153.2562 |
| 125 | 112.5118 CX | 289.2105 CC 0.5204 | 19.4075 | 138.7339 |
| 126 | 88.5495 CX | 163.9744 CC 9.5730 | 18.2007 | 121.4501 |
| 127 | A(3) | 275.3482 CC 0.6374 | 8.0308 | 113.7185 |
| 128 | 90.0474 CX | 198.6691 CC 4.0611 | 50.2333 | 93.0110 |
| 129 IMAGE DISTANCE = IM | INF INF | INF | 1.9890 | 38.3454 7.9560 18.0000 |

## ASPHÄRISCHE KONSTANTE :

$$Z = \frac{(CURV)Y^2}{1 + (1-(1+K)(CURV)^2 Y^2)^{1/2}} + (A)Y^4 + (B)Y^6 + (C)Y^8 + (D)Y^{10}$$

| ASPHERIC | CURV | K | A | B | C | D |
|---|---|---|---|---|---|---|
| A( 1) | -0.00266392 | 0.000000 | -1.16728E-07 | -4.98736E-12 | 1.05871E-15 | -1.10882E-19 |
| A( 2) | -0.00302040 | 4.403490 | -1.93335E-08 | -5.16149E-12 | 1.76471E-17 | -8.44115E-20 |
| A( 3) | 0.00157186 | 0.000000 | -6.86103E-09 | -3.01927E-12 | 4.16805E-16 | -2.20170E-20 |

TABELLE 2

| 157nm: 4x/0.75 26x8mm | | | | |
|---|---|---|---|---|
| ELEMENT NUMMER | RADIUS FRONT | HINTEN | DICKE | ÖFFNUNG DURCHMESSER FRONT |
| OB | INF | 32.0000 121.6828 10.9432 | | |
| 201 | -174.6035 CC | 321.5400 CC 6.3958 | 7.0000 | 121.6828 |
| 202 | 1194.9899 CX | -205.8222 CX 0.5000 | 18.5952 | 136.2957 |
| 203 | 1609.4638 CX | -274.1701 CX 0.5000 | 16.7329 | 148.7297 |
| 204 | 570.4350 CX | -400.5643 CX 0.5000 | 17.3278 | 154.6429 |
| 205 | 338.8401 CX | A(1) 0.5000 | 19.5696 | 152.9796 |
| 206 | 201.4588 CX | 107.1093 CC 23.6421 | 20.6507 | 139.5639 |
| 207 | -509.2957 CC | 165.7732 CC 21.1920 | 7.0000 | 120.9462 |
| 208 | -198.6045 CC | 227.4791 CC 31.4588 | 7.0000 | 118.6559 |
| 209 | -156.9194 CC | A(2) 9.3437 | 7.0000 | 135.7457 |
| 210 | -216.9046 CC | -140.7311 CX 0.9474 | 15.3058 | 154.8468 |
| 211 | 9003.1181 CX | -203.3927 CX 0.5000 | 29.8608 | 191.1726 |
| 212 | 397.8494 CX | -325.4837 CX 72.6784 | 36.7732 | 212.2835 |
| 213 | 171.5806 CX | -4452.8009 CX 2.7428 | 31.1490 | 180.8390 |
| 214 | 185.1372 CX | 113.4055 CC 29.1156 | 21.8943 | 156.4745 |
| 215 | -304.4895 CC | 320.8446 CC 18.1845 | 7.0000 | 130.1909 |
| 216 | -180.9001 CC | 211.4019 CC 39.8440 | 7.0000 | 123.8256 |
| 217 | -113.4193 CC | 3227.6629 CC 12.3152 | 7.0775 | 131.7270 |
| 218 | -411.2396 CC | -173.5699 CX 0.7069 | 18.8966 | 161.5430 |
| 219 | -8314.1361 CC | -218.2659 CX 0.6914 | 35.6647 | 190.4642 |
| 220 | 1464.1097 CX | -413.4902 CX -25.0000 | 22.5136 | 213.0816 |
| | | APERTUR STOP 32.8416 | | 211.0134 |
| | | | | 219.4460 |
| | | 3.0000 | | |

TABELLE 2   (fortgesetzt)

| ELEMENT NUMMER | RADIUS FRONT | HINTEN | DICKE | ÖFFNUNG DURCHMESSER FRONT |
|---|---|---|---|---|
| 221 | 862.4532 CX | -1051.3889 CX 0.5000 | 17.7633 | 223.5023 |
| 222 | 454.8759 CX | -413.2828 CX 16.3664 | 34.6186 | 226.6665 |
| 223 | -221.0089 CC | -533.8549 CX 19.3290 | 31.4490 | 225.5555 |
| 224 | -321.5987 CC | -220.0639 CX 0.5008 | 18.0032 | 231.1908 |
| 225 | 169.7010 CX | 436.2150 CC 0.7849 | 29.2723 | 209.2933 |
| 226 | 133.5588 CX | 247.3219 CC 14.4389 | 27.4520 | 183.2223 |
| 227 | A(3) | 415.3065 CC 0.9614 | 12.1128 | 171.5813 |
| 228 | 135.8181 CX | 299.6517 CC 6.1253 | 75.7667 | 140.3340 |
| 229 | INF       INF IMAGE DISTANCE = | 3.0000 12.0000 | 57.8902 | |
| IM | INF | | 27.2000 | |

## ASPHÄRISCHE KONSTANTE

$$Z = \frac{(CURV)Y^2}{1 + (1-(1+K)(CURV)^2 Y^2)^{1/2}} + (A)Y^4 + (B)Y^6 + (C)Y^8 + (D)Y^{10}$$

| ASPHERIC | CURV | K | A | B | C | D |
|---|---|---|---|---|---|---|
| A( 1) | -0.00176618 | 0.000000 | -3.40187E-08 | -6.38908E-13 | 5.96171E-17 | -2.74461E-21 |
| A( 2) | -0.00200252 | 4.403490 | -5.63445E-09 | -6.61216E-13 | 9.93728E-19 | -2.08941E-21 |
| A( 3) | 0.00104214 | 0.000000 | -1.99954E-09 | -3.86786E-13 | 2.34708E-17 | -5.44979E-22 |

TABELLE 3

| 157nm: 4x/0.75 17x6mm | | | | |
|---|---|---|---|---|
| ELEMENT NUMMER | RADIUS FRONT | HINTEN | DICKE | ÖFFNUNG DURCHMESSER FRONT |
| OB | INF | 32.0000 84.8858 6.8417 | | |
| 301 | -135.4093 CC | 229.3553 CC 8.9677 | 7.0368 | 84.8926 |

TABELLE 3   (fortgesetzt)

| ELEMENT NUMMER | RADIUS FRONT | HINTEN | DICKE | ÖFFNUNG DURCHMESSER FRONT |
|---|---|---|---|---|
| 302 | -587.1142 CC | -189.7989 CX 0.5238 | 24.1492 | 96.6246 |
| 303 | 970.0801 CX | -192.3938 CX 0.5000 | 16.5734 | 119.5385 |
| 304 | 529.1899 CX | -311.9989 CX 0.5000 | 14.9339 | 127.0740 |
| 305 | 349.2830 CX | A(1) 0.5000 | 57.7213 | 127.6292 |
| 306 | 95.5355 CX | 80.0780 CC 28.0759 | 7.4216 | 106.0867 |
| 307 | -168.2831 CC | 152.9631 CC 21.9848 | 7.1651 | 96.9080 |
| 308 | -509.7405 CC | 170.3994 CC 30.5973 | 7.3791 | 97.6597 |
| 309 | -163.7568 CC | A(2) 8.7087 | 7.4717 | 111.4582 |
| 310 | -191.7537 CC | -132.1552 CX 0.7751 | 15.4691 | 123.9992 |
| 311 | -3068.5173 CC | -207.2864 CX 1.7561 | 30.2084 | 145.3721 |
| 312 | 452.9540 CX | -302.0775 CX 15.0782 | 50.9848 | 161.9745 |
| 313 | 184.2073 CX | -852.4844 CX 2.0300 | 27.4056 | 156.8187 |
| 314 | 193.6735 CX | 104.8016 CC 25.5897 | 20.4756 | 138.3805 |
| 315 | -267.6202 CC | 389.1276 CC 13.8184 | 7.0000 | 116.6552 |
| 316 | -209.6258 CC | 229.3549 CC 39.3155 | 9.8674 | 113.3445 |
| 317 | -112.5355 CC | 1428.0917 CC 12.1163 | 7.0498 | 123.7205 |
| 318 | -513.9830 CC | -177.1624 CX 0.5025 | 18.8131 | 152.8362 |
| 319 | -6367.0019 CC | -217.2489 CX 1.4058 | 35.7995 | 177.7169 |
| 320 | 10263.8608 CX | -383.6591 CX 0.1919 | 28.1866 | 197.5246 |
|  |  | APERTUR STOP 31.5278 |  | 202.8911 |
|  |  | 3.0000 |  | 212.0771 |
| 321 | 3132.5342 CX | -826.3717 CX 5.5342 | 14.8348 | 213.8222 |
| 322 | 365.2260 CX | -371.2824 CX 15.2812 | 38.0908 | 220.1417 |
| 323 | -210.6493 CC | -403.5697 CX 16.7168 | 8.2553 | 218.9190 |
| 324 | -278.1561 CC | -213.3805 CX 0.8777 | 34.9977 | 220.1415 |

TABELLE 3   (fortgesetzt)

| ELEMENT NUMMER | RADIUS FRONT | HINTEN | DICKE | ÖFFNUNG DURCHMESSER FRONT |
|---|---|---|---|---|
| 325 | 170.4222 CX | 474.9380 CC 0.5616 | 28.2159 | 200.4015 |
| 326 | 135.3877 CX | 232.6450 CC 13.7033 | 27.1639 | 175.2321 |
| 327 | A(3) | 406.4696 CC 0.5322 | 11.5043 | 159.6505 |
| 328 | 131.3181 CX | 286.5078 CC 5.6921 | 75.6193 | 131.7867 |
| 329 | INF      INF | 3.0000 12.0003 | 48.6905 | |
| | IM       INF | | 18.0000 | |

ASPHÄRISCHE KONSTANTE

$$Z = \frac{(CURV)Y^2}{1 + (1-(1+K)(CURV)^2 Y^2)^{1/2}} + (A)Y^4 + (B)Y^6 + (C)Y^8 + (D)Y^{10}$$

| ASPHERIC | CURV | K | A | B | C | D |
|---|---|---|---|---|---|---|
| A( 1) | -0.00442028 | 0.000000 | -4.53266E-08 | 1.67151E-12 | -4.93581E-18 | -1.68355E-21 |
| A( 2) | -0.00223038 | 4.403490 | 1.38023E-08 | -2.44399E-12 | 1.81046E-17 | -7.23412E-21 |
| A( 3) | 0.00127570 | 0.000000 | -2.95475E-09 | -3.47798E-13 | 1.98122E-17 | -4.57061E-22 |

Bezugszeichenliste:

1    Lichtquelle
11   Laser
12   Bandbreiteneinengung
2    Ankopplung/Laser beam line
3    Beleuchtungssystem
31   Divergenzerhöhung
32   Beleuchtungsart + Kohärenzfaktor (Zoom-Axicon)
33   Integrator/Lichttauscher
34   Anpassungsoptik (REMA)-Objektiv
4    Retikel
5    Projektionsobjektiv
6    Wafer


**Patentansprüche**

1.  Projektionsbelichtungsanlage der Mikrolithographie

    -   mit einer Lichtquelle mit einer Wellenlänge unter 200 nm und
    -   einer Bandbreite kleiner als 0,3 pm vorzugsweise unter 0,25 pm und größer als 0,1 pm.
    -   mit einem rein refraktiven Projektionsobjektiv mit nur einem Linsenmaterial, **gekennzeichnet durch** die Ausbildung
    -   mit einer größten Bildhöhe über 12 mm bis etwa 25 mm
    -   mit einer bildseitigen numerischen Apertur von über 0,75 bis etwa 0,95
    -   mit einer monochromatischen Korrektur der Wellenfront auf rms < 15‰ der Wellenlänge der Lichtquelle

2.  Projektionsbelichtungsanlage der Mikrolithographie nach Anspruch 1, **dadurch gekennzeichnet, daß**
    ein Beleuchtungssystem vorgesehen ist mit
    Erhöhung des Lichtleitwerts, Homogenisierung, veränderlicher Beleuchtungsapertur, insbesondere umfassend Ringapertur, Dipol- und Quadrupolbeleuchtung und mit veränderlicher Kohärenz.

3.  Projektionsbelichtungsanlage nach Anspruch 1 oder Anspruch 2, **dadurch gekennzeichnet, daß**
    das Projektionsobjektiv mindestens eine asphärische Fläche aufweist.

4.  Projektionsbelichtungsanlage nach Anspruch 3 mit einem Projektionsobjektiv mit 5 Linsengruppen, deren zweite und vierte negative Brechkraft haben, **dadurch gekennzeichnet, daß** die erste Linsengruppe (LG1) mindestens eine asphärische Fläche aufweist.

5.  Projektionsbelichtungsanlage nach Anspruch 3 oder 4 mit einem Projektionsobjektiv mit 5 Linsengruppen, deren zweite und vierte negative Brechkraft haben, **dadurch gekennzeichnet, daß** die dritte Linsengruppe (LG3) mindestens eine asphärische Fläche aufweist.

6.  Projektionsbelichtungsanlage nach mindestens einem der Ansprüche 3 bis 5 mit einem Projektionsobjektiv mit 5 Linsengruppen, deren zweite und vierte negative Brechkraft haben, **dadurch gekennzeichnet, daß** negative Linsen der fünften Linsengruppe (LG5) Asphären aufweisen.

7.  Projektionsbelichtungsanlage nach mindestens einem der Ansprüche 3 bis 6 mit einem Projektionsobjektiv mit 5 Linsengruppen, deren zweite und vierte negative Brechkraft haben, **dadurch gekennzeichnet, daß** die Mehrzahl der asphärischen Flächen konvex ist.

8.  Projektionsbelichtungsanlage nach mindestens einem der Ansprüche 1 bis 7, **dadurch gekennzeichnet, daß** das Linsenmaterial ein Fluorid, insbesondere $CaF_2$, $BaF_2$ oder LiF, ist.

9.  Projektionsbelichtungsanlage nach mindestens einem der Ansprüche 1 bis 8, **dadurch gekennzeichnet, daß** die chromatische Längsaberration CHL (in nm/pm) des Projektionsobjektivs kleiner ist als 5 ‰ der Wellenlänge des Lichts der Lichtquelle.

10. Projektionsbelichtungsanlage nach mindestens einem der Ansprüche 1 bis 9, **dadurch gekennzeichnet, daß** die Wellenlänge der Lichtquelle ca. 157 nm beträgt.

# FIG.1

EP 1 304 594 A2

# FIG.2

0b

AS

Im

101 103 105 107 109 111 113 115 117 119 121 123 125 127 129

102 104 106 108 110 112 114 116 118 120 122 124 126 128

131.58 MM

EP 1 304 594 A2

## FIG.3

0b

AS

Im

201 | 203 | 205 | 207 | 209 | 211   213 | 215 | 217 | 219 | 221 | 223   225 | 227 | 229

202 204 206 208 210 212   214 216 218 220 222 224 226 228

131.58 MM

EP 1 304 594 A2

FIG.4